# EUROPÄISCHE PATENTSCHRIFT

(11) **EP 1 012 613 B1**
(45) Veröffentlichungstag und Bekanntmachung des Hinweises auf die Patenterteilung: **24.04.2002**
(21) Anmeldenummer: 98949907.4
(22) Anmeldetag: 11.08.1998
(51) Int. Cl.: G01R 31/28, G01R 1/067

(54) **VERFAHREN UND VORRICHTUNG ZUR GEPULSTEN HOCHSTROMBELASTUNG INTEGRIERTER SCHALTUNGEN UND STRUKTUREN**
METHOD AND DEVICE FOR CHARGING INTEGRATED CIRCUITS AND STRUCTURES WITH A PULSED HIGH INTENSITY CURRENT
PROCEDE ET DISPOSITIF PERMETTANT D'APPLIQUER UN COURANT PULSE DE FORTE INTENSITE A DES CIRCUITS ET DES STRUCTURES INTEGRES

(30) Priorität: 11.09.1997 DE 19739923
(43) Veröffentlichungstag der Anmeldung: 28.06.2000
(73) Patentinhaber: FRAUNHOFER-GESELLSCHAFT ZUR FÖRDERUNG DER ANGEWANDTEN FORSCHUNG E.V., 80636 München (DE)
(72) Erfinder: GIESER, Horst, D-81669 München (DE)
(74) Vertreter: Gagel, Roland, Dr.
(86) Internationale Anmeldenummer: DE9802391
(87) Internationale Veröffentlichungsnummer: WO9913349

(56) Entgegenhaltungen:
- US-A- 5 506 515
- US-A- 5 594 358
- GIESER H ET AL: "Very-fast transmission line pulsing of integrated structures and the charged device model" ELECTRICAL OVERSTRESS/ELECTROSTATIC DISCHARGE SYMPOSIUM PROCEEDINGS. 1996 (IEEE CAT. NO.96TH8150), PROCEEDINGS OF 18TH ANNUAL ELECTRICAL OVERSTRESS/ELECTROSTATIC DISCHARGE SYMPOSIUM, ORLANDO, FL, USA, 10-12 SEPT. 1996, Seiten 85-94, XP002089929 1996, Rome, NY, USA, ESD Assoc, USA in der Anmeldung erwähnt

## Beschreibung

Die Erfindung betrifft ein Verfahren und eine Vorrichtung zur gepulsten Hochstrombelastung integrierter Schaltungen und Strukturen.

Eine der Hauptausfallursachen integrierter Schaltungen sind elektrostatische Entladungen (ESD = Electrostatic Discharge), bei welchen der Entladungsstrom durch die integrierte Schaltung fließt. Zusammen mit den davon schwer abgrenzbaren elektrischen Überbelastungen (EOS = Electrical Overstress) verursachen sie etwa 50 % der Feldausfälle. Als Ladungsquelle für die ESD kommen externe Kapazitäten, wie der menschliche Körper (Human Body) oder auch der Baustein selbst (Charged Device) mit der integrierten Schaltung im Inneren in Frage. Die Aufladung erfolgt durch Reibung (Triboelektrizität) oder durch Induktion und Kontakt im elektrostatischen Feld.

Zum Schutz der integrierten Schaltungen werden Schutzstrukturen an deren Ein- und Ausgängen eingesetzt. Diese Schutzstrukturen sollen einerseits keinen Einfluß auf die Funktionalität der Schaltung haben, aber andererseits im Entladungsfall verzögerungsfrei hohe Ströme auf sicheren Pfaden um den Schaltungskern herum oder aus diesem ableiten, und dabei die Spannungen auf für das Innere (z.B. Gateoxide) der Schaltung unkritische Werte begrenzen. Zur Synthese eines solchen Schutzkonzeptes ist eine genaue Kenntnis des Verhaltes dieser Strukturen in den relevanten Strom- und Zeitbereichen unverzichtbar.

Für die industrielle Produktqualifikation muß darüber hinaus die Wirksamkeit eines solchen Schutzkonzeptes im Hinblick auf die unterschiedlichen in der Realität vorkommenden elektrostatischen Belastungsarten verifiziert und quantifiziert werden. Die Qualifikation muß getrennt nach Gehäusen erfolgen. Hierzu wurden charakteristische Belastungsmodelle wie das Human Body Model (HBM) und das Charged Device Model (CDM) mit ihren Derivaten definiert. Diese unterscheiden sich im wesentlichen in ihren Strom- und Zeitbereichen. Das Human Body Model besitzt infolge der Festlegung auf einen 1,5 k Serienwiderstand und einen 100 pF Kondensator eine innerhalb von bis zu 10 ns auf etwa 0,66 A/kV Vorladespannung ansteigenden über zwei Anschlüsse der integrierten Schaltung fließenden, doppelexponentiellen Stromverlauf. Dem gegenüber wird die Kapazität der CDM-Entladung nur durch den Baustein selbst bzw. seine leitfähigen Bestandteile in bezug auf seine Umgebung definiert. Mit zunehmender Chip- und Gehäusefläche, bedingt durch steigende Pinzahlen (> 300), und abnehmender Gehäusestärke wächst diese Kapazität. Die Bedrohung beginnt beim Trennen der Anschlüsse nach dem Verpressen des Chips im Kunststoffgehäuse und ist auch mit seinem Einbau in eine Leiterplatte noch nicht beendet. Durch die zunehmende Automatisierung nimmt auch die Wahrscheinlichkeit einer Belastung nach dem Charged Device Model zu. Neben dem Ladungsaustausch über einen einzelnen Anschluß der Schaltung zeichnet sich das CDM auch durch seine sehr hohen, nur durch die Anschlußinduktivität und den Funkenwiderstand begrenzten Ströme von bis zu mehreren Ampere aus, die innerhalb von Bruchteilen einer Nanosekunde erreicht werden.

Aufgrund der hohen Ströme können sich über den Schutzstrukturen und Versorgungsleitungen hohe Spannungsabfälle von mehreren 10 V aufbauen, die auch dann, wenn die Schutzstruktur ausreichend schnell anspricht, zu einer Bedrohung für die immer dünneren Gateoxide werden. Mit abnehmendem Abstand der Durchbruchspannung von Gateoxiden und von pn-Übergängen zu deren Schutz und komplexeren Versorgungsbussystemen nimmt die Bedrohung durch die extrem kurzen Impulse hoher Stromstärke des CDM weiter zu.

Die Quantifizierung der elektrostatischen Belastbarkeit erfolgt bisher in ESD-Testern, in welchen die unterschiedlichen Belastungsmodelle implementiert wurden. Die Charakterisierung von Schutzelementen und integrierten Strukturen im Hochstrombereich kann mittels Rechteckimpulsen erfolgen, die in der Regel durch die Entladung von Leitungen erzeugt werden, und an die beiden Anschlüsse eines Schutzelements angelegt werden.

Die ESD-Belastbarkeit integrierter Schaltungen nach dem CDM erfolgt bisher in Testern, die sich in der Art des Entladekontakts, der Art der Bausteinhalterung und dem Prinzip der Aufladung unterscheiden. Die Standardisierung des Testverfahrens wurde und wird durch erhebliche Korrelationsprobleme stark behindert. Eine Ursache dafür sind die bei den sehr kurzen Impulsen auftretenden komplexen Wechselwirkungen zwischen der integrierten Schaltung, ihrem Gehäuse, dem Testadapter und dem Tester selbst. Diese Wechselwirkungen beeinflussen zum einen den Entladestrom und zum anderen seine Wirkung auf die Schaltung. Ein Schlüsselproblem ist die für einzelne, derart steile Stromanstiege (< 100 ps) unzureichende Impulsmeßtechnik.

Bei den bekannten CDM-Testern werden im wesentlichen unterschieden:

### 1) non-contact, non-socketed (nn):

Der aufgeladene Baustein liegt in rückwärtiger Position auf einer geerdeten leitfähigen Unterlage. Zur Belastung wird eine geerdete Elektrode geringer Induktivität an den zu belastenden Anschluß des Bausteins herangeführt. Die Entladung erfolgt dann je nach Feldstärke und Zündbedingung durch Funken oder metallischen Kontakt.
Dieses Verfahren zeigt jedoch eine schlechte Reproduzierbarkeit des Stromverlaufs bei Vorladespannungen über 1 kV. Weiterhin
ist der Kontakt bei senkrecht stehenden (DIL), sehr kleinen oder gar verbogenen Anschlüssen unsicher. Durch mechanischelektrische Federkontakte treten weitere Unsicherheiten auf. Durch die mechanische Positionierung ist nur ein langsamer Testablauf möglich. Die unzureichende Bandbreite der zur Verfügung stehenden Impulsmeßtechnik schafft weitere Probleme. Die für die Messung des Entladestroms benötigten empfindlichen HF-Kabel und Verbindungen können durch häufige Neupositionierung während des Tests vorzeitig altern und das Testergebnis verfälschen.

### 2) contact, non-socketed (cn):

Der aufgeladene Baustein liegt in rückwärtiger Position auf einer geerdeten, leitfähigen Unterlage. Ein geöffnetes Relais verbindet den aufgeladenen Baustein mit der Masse des Testers. Zur Belastung wird ein Relais geschlossen.
Bei diesem Verfahren tritt jedoch nur eine verlangsamte Entladung niedriger Amplitude aufgrund des Relais und seiner Induktivität auf. Das Verfahren zeigt eine schlechte Reproduzierbarkeit des Stromverlaufs bei Vorladespannungen über 1 kV durch Funkenentladung. Weiterhin ist der Kontakt bei sehr kleinen oder gar verbogenen Anschlüssen unsicher. Durch die mechanische Positionierung ist nur ein langsamer Testablauf möglich. Die Meßtechnik des Verfahrens ist nur bedingt auf die des Typ "nn" abbildbar.

### 3) non-contact, socketed (ns):

Der Baustein befindet sich in einem Testsockel, ggf. auf einem Testadapter, einer Leiterplatte zur Erhöhung der Abstände zwischen den Anschlüssen. Der gesamte Testsockel einschließlich aller daran befindlichen Leitungen wird gegenüber dem Testsystem aufgeladen. Zur Belastung wird ein Anschluß durch Annäherung von zwei Kontakten unter atmosphärischen Bedingungen kontaktiert. Die hinter dem Baustein befindliche Sockel- und Boardkapazität (Hintergrundkapazität) entlädt sich über diesen Anschluß.
Bei diesem Verfahren bestimmt ein komplexes System von Leitungen und Leitungsabschlußwiderstand die komplexe Entladestromform und kann in Verbindung mit der integrierten Schaltung zu unvorhersehbaren Effekten führen. Mangels signifikanter Impulsmeßmethoden ist das Ergebnis nur schwer oder überhaupt nicht auf andere Systeme desselben oder eines anderen Typs übertragbar. Nachteilig ist weiterhin, daß Hintergrundkapazitäten mit Einfluß auf die Ausfallspannung und die physikalische Ausfallsignatur die gespeicherte Energie erhöhen.

### 4) contact, socketed (cs):

Der Baustein befindet sich in einem Testsockel, ggf. auf einem Testadapter, einer Leiterplatte zur Erhöhung der Abstände zwischen den Anschlüssen. Der gesamte Testsockel einschließlich aller daran befindlichen Leitungen wird gegenüber dem Testsystem aufgeladen. Zur Belastung wird ein Anschluß über ein oder mehrere Relais kontaktiert, und die hinter dem Baustein befindlichen Sockel- und Boardkapazität (Hintergrundkapazität) entlädt sich über diesen Anschluß.
Die Nachteile dieses Verfahrens entsprechen denen des vorangehenden Typs "ns".

Bei den Testsystemen ohne Sockel ist auch eine feldinduzierte Aufladung möglich. Dabei wird das Potential der Elektrode unter dem Baustein zum Aufladen angehoben und der Kontakt mit der Masseelektrode zum erstenmal kurzzeitig hergestellt. Das Potential der Elektrode wird daraufhin wieder abgesenkt und der Kontakt mit der Masseelektrode ein zweites Mal wiederhergestellt. Dabei wird der Baustein in der Regel zweifach mit alternierender Polarität belastet.

Ein weiteres bekanntes Verfahren betrifft das in Japan gebräuchliche "Small Capacitor Model" (SCM), bei welchem ein aufgeladener 10 pF Kondensator in Kontakt mit dem zu belastenden Bausteinanschluß gebracht wird. Die Reproduzierbarkeit und Übertragbarkeit hängt auch hier sehr stark vom tatsächlichen Aufbau ab.

Alle bisher vorgestellten Testsysteme belasten ausschließlich gehäuste integrierte Schaltungen und Module. Würde man sie direkt zum Test auf Scheibenebene (Waferebene) einsetzen, müßte eine auf ± 20 µm genaue Positionierung der Spitze erfolgen. Die Kapazität würde sich bei aktuellen Aufbauten im wesentlichen zwischen dem Siliziumsubstrat und dem davon isolierten Substratträger aufbauen, und die mobile Ladung damit an der Substratunterseite der integrierten Schaltung sitzen. Dies steht jedoch im Gegensatz zur Ladungsverteilung bei gehäusten Bausteinen, die nach dem CDM ohne Sockel belastet werden. Hier sitzt die mobile Ladung auf der Metallisierung an der Chipoberfläche und den metallischen Teilen des Gehäuses.
Die Vor- und Nachteile der vorgestellten Testsysteme sind insbesondere im Hinblick auf Reproduzierbarkeit und Übertragbarkeit der Belastung komplementär. Eine gravierende Verbesserung auf der Grundlage der bestehenden Systeme ist nicht vorstellbar, da in den vorwiegend pragmatisch auf die Reproduktion von Feldausfällen ausgerichteten Ansätzen eine ineinander überführbare, physikalisch eindeutige Definition fehlt.

Ein für die Charakterisierung von integrierten Strukturen angewandter, sehr schneller Rechteck-Impulsgenerator wird eingehend in H. Gieser, M. Haunschild, "Very-Fast Transmission Line Pulsing of Integrated Structures and the Charged Device Model", Proc. of the EOS/ESD-Symposium, Phönix, USA, 1996, S. 85ff. erörtert. Bei diesem Gerät handelt es sich um einen Rechteck-Impulsgenerator nach dem Transmission-Line-Verfahren, der Impulse zwischen 3,5 ns und 11,5 ns Dauer erzeugt und nach dem in der Hochfrequenztechnik üblichen Zeitbereichsreflektometrieverfahren (TDR) in eine integrierte Struktur über zwei Anschlüsse einkoppelt.
Durch numerische Überlagerung des hin- und rücklaufenden Spannungsimpulses wird die Spannungs- und Strombelastung an der untersuchten integrierten Struktur ermittelt.

Eine Vorrichtung und ein Verfahren zum Messen der Hochfrequenzcharakteristik von integrierten Schaltungen ist aus der US-A-5 594 358 bekannt. Bei dieser Anordnung geht es allerdings nicht um die Hochstrombelastung integrierter Schaltungen sondern um die Erfassung der normalen Hochfrequenzeigenschaften der Systeme. Die Prüfvorrichtung weist eine Halterung zur Aufnahme eines Substrates mit der integrierten Schaltung und einen Impulsinjektor mit Referenzelektrode und Kontaktelektrode zur Kontaktierung von Anschlußflächen der integrierten Schaltung sowie einen Träger für Kontakt- und Referenzelektrode auf. Referenz- und Kontaktelektrode sind als dicht nebeneinander liegende Stifte ausgebildet, die über entsprechende Anschlußflächen der integrierten Schaltung justiert werden und diese im Meßzustand gleichzeitig kontaktieren. Die Anschlußflächen werden dann mit definierten Hochfrequenzsignalen beaufschlagt.

Der Erfindung liegt die Aufgabe zugrunde, ein Verfahren und eine Vorrichtung zur gepulsten Hochstrombelastung integrierter Schaltungen und Strukturen anzugeben, die es ermöglichen, vollständige integrierte Schaltungen mit und ohne Gehäuse, auch auf Waferebene, vergleichbar und reproduzierbar mit sehr kurzen Hochstromimpulsen zu belasten und deren Belastbarkeit im Hinblick auf CDM-typische Ausfallmechanismen zu quantifizieren.
Die Überwachung der elektrischen Fehlerkriterien vor und nach der Belastung soll ohne große Umbauten möglich sein. Durch das Verfahren soll weiterhin die Effizienz und physikalisch begründete Signifikanz des gesamten Qualifikationsvorgangs gesteigert werden. Anstelle von individuellen, schwer kalibrierbaren Detaillösungen sollen kosteneffiziente und weitgehend standardisierte Komponenten und Systeme entsprechend dem Stand der Technik eingesetzt werden können.

Die Aufgabe wird mit den Merkmalen der Vorrichtung nach Anspruch 1 und des Verfahrens nach Anspruch 18 gelöst. Besonders vorteilhafte Ausgestaltungen sind Gegenstand der Unteransprüche.

Zur Quantifizierung der elektrostatischen Empfindlichkeit und zur Extraktion von Hochstromparametern von integrierten Schaltungen und Einzelstrukturen (DUT-"Device under Test") werden ein Verfahren und eine Vorrichtung vorgeschlagen, bei denen unter sehr definierten Randbedingungen ein hoher Stromimpuls über einen Anschluß in das DUT injiziert werden kann. Das Substrat, in welchem die zu untersuchende Schaltung integriert ist, bildet mit der auf definiertem Abstand befindlichen Referenzelektrode einen von der aktuellen Schaltung abhängigen, die Belastungsparameter bestimmenden Kondensator, dessen Dielektrikum in der Regel aus Luft besteht.
Das Verfahren zeichnet sich durch einen im Gesamtsystem nahezu konstanten, durch die mechanischen und die Materialeigenschaften definierten Wellenwiderstand aus. Als Substrat kann auch eine vollständige Halbleitersubstratscheibe (Wafer) mit einer Vielzahl von Schaltungen eingesetzt werden.
Vorteilhafterweise erfolgt ein Einsatz von mit geringer Streuung impulserzeugenden Elementen (Relais, Festkörperschalter)ausreichender Spannungsfestigkeit (z.B. 1 kV) und kurzer Schaltzeit (z.B. 300 ps). Die Möglichkeit zur Insitu-Messung der auf das Bauelement zulaufenden und von ihm reflektierten Impulse kann ebenfalls vorgesehen sein.
Darüber hinaus kann durch einen einfachen Austausch des kapazitiv gekoppelten Strominjektors gegen einen Injektor mit zwei Anschlüssen oder durch das Einsetzen einer weiteren Kontaktelektrode in eine Halterung an der Referenzelektrode auch eine Strom-Spannungscharakterisierung von integrierten Strukturen bis in den Hochstrombereich durchgeführt werden. Adressiert werden durch dieses Verfahren und diese Vorrichtung Ausfallmechanismen und Impulsbereiche des elektrostatischen Belastungsmodells "Charged Device Model (CDM)", bei welchem die Belastung in der Realität nahezu ausschließlich durch den Baustein selbst und die zwischen ihm und der Umgebung innerhalb weniger Nanosekunden ausgetauschte Ladung bestimmt wird.

Im folgenden werden die erfindungsgemäße Vorrichtung und das erfindungsgemäße Verfahren in Ausführungsbeispielen anhand der Figuren 1 bis 6 näher erläutert. Hierbei zeigen (nicht maßstäblich):
- Fig.1: ein Beispiel für die erfindungsgemäße Vorrichtung im Querschnitt;
- Fig.2: die Vorrichtung aus Fig.1 in Draufsicht;
- Fig.3: ein Beispiel für den Einsatz der erfindungsgemäßen Vorrichtung;
- Fig.4: ein zweites Beispiel für den Einsatz der erfindungsgemäßen Vorrichtung;
- Fig.5: ein drittes Beispiel für den Einsatz der erfindungsgemäßen Vorrichtung; und
- Fig.6: ein Beispiel einer weiteren Vorrichtung im Querschnitt (a) und in Draufsicht (b), mit der das erfindungsgemäße Verfahren durchgeführt werden kann.

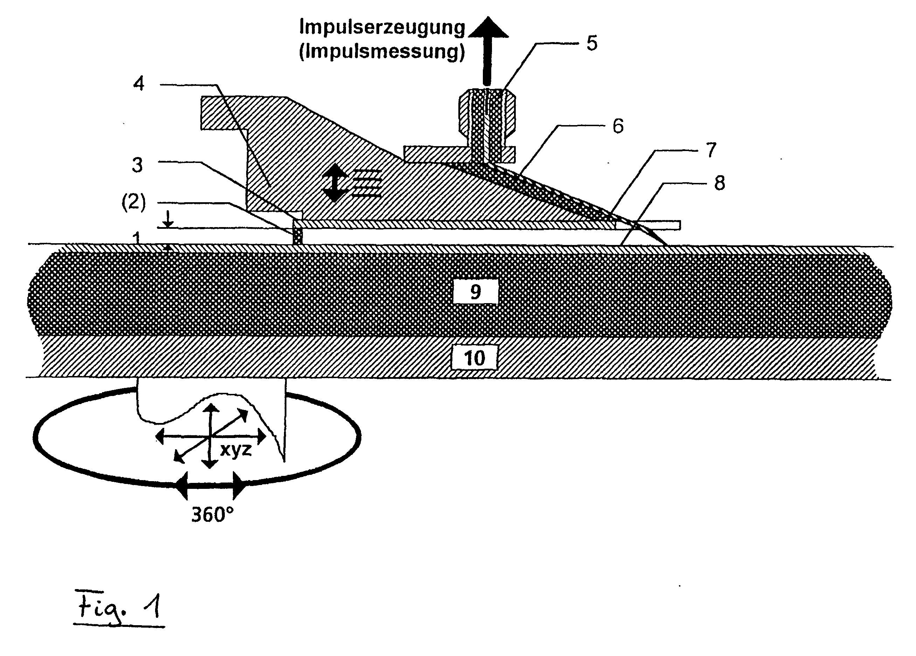

Ein Beispiel einer erfindungsgemäßen Vorrichtung für die Impulsinjektion in einen zu belastenden Anschluß einer integrierten Schaltung ist in Fig. 1 gezeigt. Sie setzt sich zusammen aus der Referenzelektrode 3, die in einem definierten Abstand 1 über einem Substrat 8 eingestellt ist. Die Substrathalterung besteht aus einer Trägerplatte 10 und einem darauf befindlichen Isolator 9. Die Substrathalterung ist in x-,y-,und z-Richtung justierbar sowie um 360° drehbar. Weiterhin umfaßt die Vorrichtung eine nadelförmige Kontaktelektrode 7 und den Träger 4 für Referenz- und Kontaktelektrode. Zwischen Referenzelektrode 3 und Substrat 8 kann ein Abstandshalter 2 vorgesehen sein.

Die Kapazität der auf dem Substrat 8 befindlichen integrierten Schaltung ist definiert durch die Summe der Teilkapazitäten zwischen der integrierten Schaltung und der Referenzelektrode 3 und der integrierten Schaltung und dem als Elektrode betrachteten Substratträger 10. Die Dicke und Dielektrizitätskonstante des Dielektrikums 9 ist so zu bemessen, daß der untere Teilkapazitätsbeitrag vernachlässigbar klein bleibt. Die Fläche der Referenzelektrode soll die Abmessungen der maximal zu testenden integrierten Schaltungen auf drei Seiten um mindestens mehrere Höhen 1 überragen. Die Höhe 1 kann entsprechend dem Stand der Technik durch einen vertikal kalibrierten, schrittmotorbetriebenen Manipulator oder Substratträger oder mittels kalibrierten Mikrometerschrauben mit isolierenden Zwischenstücken eingestellt werden. Beispielsweise kann der Abstand der Referenzelektrode von der Substratoberfläche 0,5 mm betragen. Als Substrathalterung kann die metallische Platte eines Waferprobers mit einem aufliegenden Dielektrikum aus Polyethylen mit einer Dicke von 5 mm dienen. Die Fläche der Referenzelektrode wird je nach Größe der zu testenden Schaltungen zwischen 100 und 1000 mm² betragen.
Aus der Veränderungsmöglichkeit des Abstandes resultiert die Möglichkeit für Qualifikationen in Abhängigkeit von der Kapazität der integrierten Schaltung.
Eine konstante Höhe 1 kann auch durch dünne Bolzen oder eine dünne Leiste aus isolierenden, formstabilen Isolatoren, die außerhalb der Abmessungen der integrierten Schaltung auf dem Substrat 8 oder korrigiert um die Dicke des Substrates an dem Isolator 9 aufliegen, definiert werden. Die Referenzelektrode 3 ist befestigt am Injektorträger 4, der wiederum an einem kommerziellen Manipulator eines Scheibenprüfautomaten befestigt werden kann. Eine für die Anwendung ausreichende mechanische Genauigkeit und Schwingungsfestigkeit des Aufbaus wird dabei für eine zuverlässige Konstanz der Kapazität und Kontaktierung der integrierten Schaltung vorausgesetzt.
Als Halterung kann auch eine Vakuumhalterung eingesetzt werden. Die Löcher dieser Vakuumhalterung beeinflussen die zwischen Referenzelektrode und integrierter Schaltung bestehenden Teilkapazitäten nicht, da der Teilkapazitätsbeitrag der Halterung, wie oben erläutert, vernachlässigbar klein bleibt.
Die wellenwiderstandsangepaßte Kontaktierung der integrierten Schaltung erfolgt mittels dem an seinem einen Ende als Nadel, Kegelstumpf oder Halbkugel ausgebildeten Leiter 7, der mit einem Dielektrikum 6 und dem Injektorträger 4 eine dem Wellenwiderstand des Gesamtsystems entsprechende Leitung bildet. Ein standardisiertes HF-Anschlußelement 5 befindet sich am anderen Ende der Kontaktleitung und verbindet den Impulsinjektor mit der Hochstrom-Impulsleitung. Bei Einsatz einer Impulserzeugungsvorrichtung nach dem Transmission-Line-Verfahren unter Verwendung von 50 Ω-Impulsleitungen kann das Gesamtsystem aus Impulserzeuger, Impulsleitung und Injektor auf einen Wellenwiderstand von 50 Ω abgestimmt sein. Dadurch liegen bis zum Anschluß der integrierten Schaltung streng definierte Verhältnisse vor, so daß der Einfluß auf die Impulsform minimal bleibt.
Die Kontaktierung ist durch eine Aussparung in der Referenzelektrode zu führen, so daß mittels eines Mikroskops oder eines automatischen Mustererkennungssystems auf die jeweilige Anschlußfläche (Pad) der integrierten Schaltung justiert werden kann.

Bei dem Verfahren wird beispielsweise zunächst die zu belastende integrierte Schaltung auf dem Substrat ausgesucht, Danach erfolgt eine Grobjustierung der Referenzelektrode über die integrierte Schaltung mittels Drehung, x-, y- und z-Verschiebung. Schließlich erfolgen die Feinjustierung des Abstandes der Referenzelektrode und die Feinjustierung der Kontaktelektrode über das Anschlußpad. Nach der Kontaktierung wird die Schaltung mit dem Stromimpuls belastet.

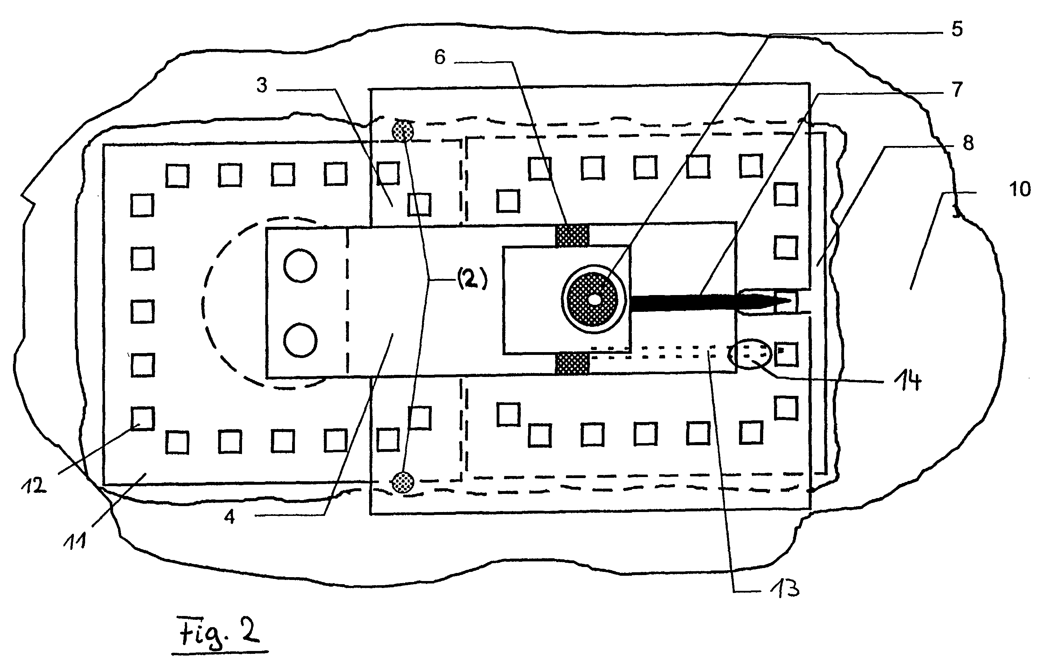

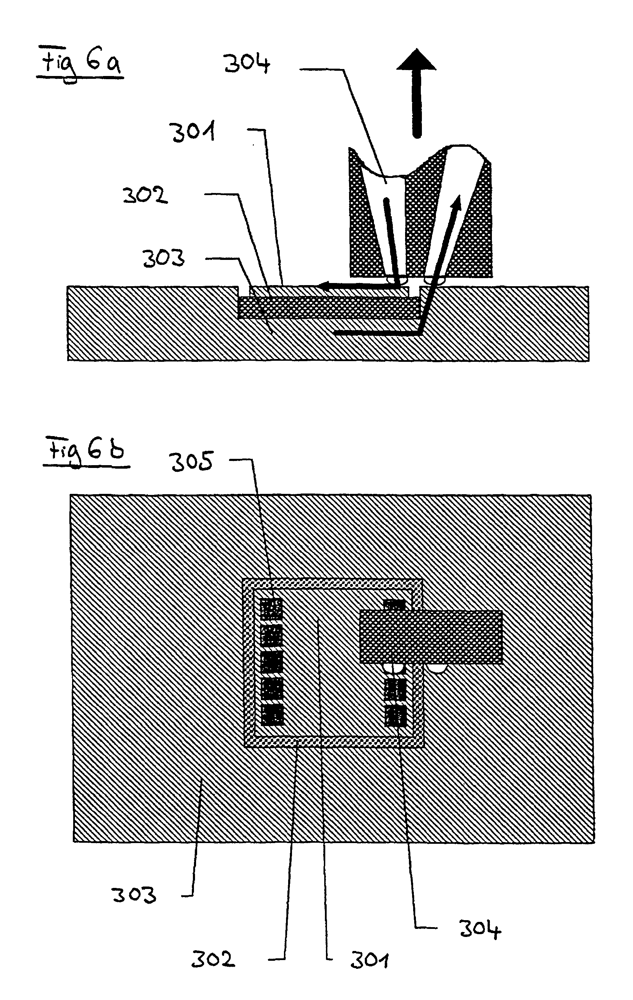

In der Draufsicht in Fig. 2 sind weiterhin die Anschlußflächen 12 zweier integrierter Schaltungen 11 gezeigt. Aus dieser Figur ist zudem die nahezu vollständige Überdeckung der zu belastenden Schaltung mit der Referenzelektrode 3 zu erkennen. Durch das Überstehen der Fläche der Referenzelektrode 3 über die Fläche der integrierten Schaltung 11 auf drei Seiten um ein Mehrfaches des Abstandes zwischen beiden wird der Einfluß von Randkapazitäten vermindert.
Weiterhin ist gestrichelt die Position gezeigt, an der eine weitere Kontaktelektrode 13 eingesetzt werden kann, um insgesamt zwei Anschlußpads zu kontaktieren. Auf diese Weise läßt sich beispielsweise ein Massekontakt zur Hochstromcharakterisierung (vgl. Fig. 5) herstellen. Diese weitere Kontaktelektrode wird durch eine Öffnung 14 der Referenzelektrode geführt.

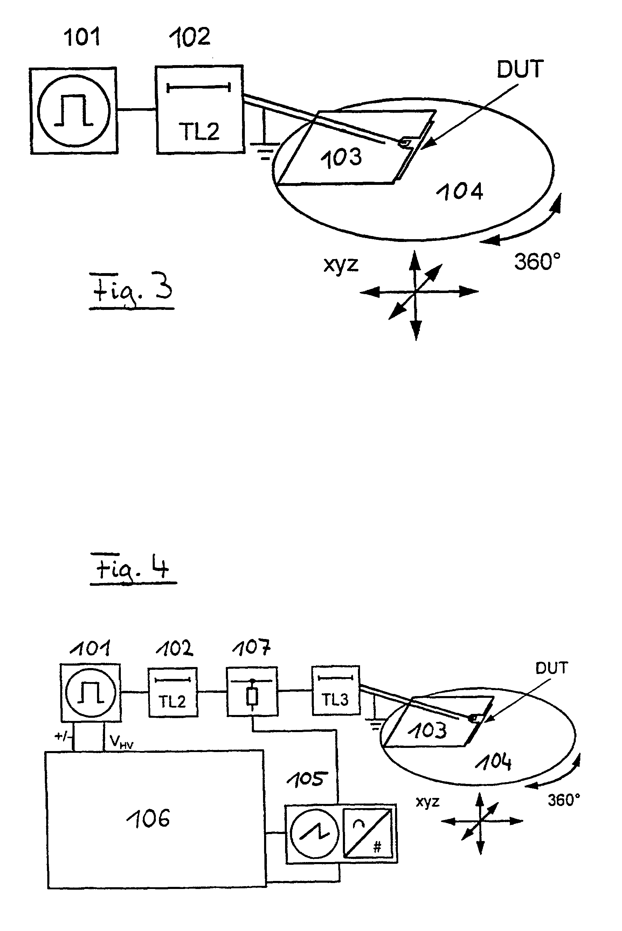

Fig.3 zeigt ein Beispiel für den Einsatz der erfindungsgemäßen Vorrichtung. Das gezeigte System zur Impulsbelastung einer integrierten Schaltung (DUT) besteht aus dem Rechteckimpulsgenerator 101, der Übertragungsleitung 102, dem kapazitiv gekoppelten Strominjektor 103 und der Substrathalterung 104. Das DUT liegt fest auf der Substratund Bausteinhalterung 104, die in diesem Fall drei translatorische und eine Rotationsachse aufweist (nicht maßstäblich gezeichnet).

Die Impulserzeugung kann entsprechend dem Stand der Technik entweder reproduzierbar mittels eines koaxialen Relais oder einem Festkörperschalter erfolgen. Dazu wird eine aufgeladene Koaxialleitung mit definiertem Wellenwiderstand entladen. Zur Bedämpfung von Mehrfachreflexionen wird ein koaxiales Dämpfungsglied 204 ausreichender Spannungsfestigkeit in die Impulsleitung integriert. Beim Einsatz eines Generators wird die Leitung quellseitig abgeschlossen.

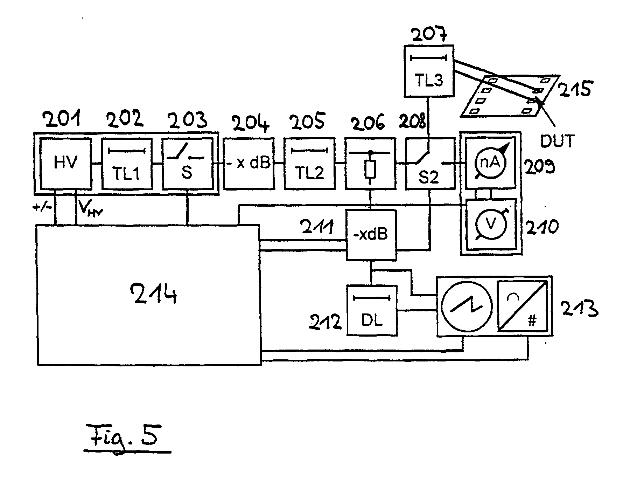

Fig.4 zeigt ein erweitertes Beispiel für den Einsatz der erfindungsgemäßen Vorrichtung. Das gezeigte System weist zusätzlich eine Vorrichtung zur Impulsmessung 105 zur Überwachung der Belastung und einen Steuerrechner 106 auf. Der Steuerrechner erfüllt die Aufgaben der Systemsteuerung, Datenverarbeitung und Datenspeicherung.

Fig 5 zeigt schließlich ein Realisierungsbeispiel für die Hochstromcharakterisierung von Elementen mit zwei Anschlüssen. Es weist einen Rechteckimpulsgenerator nach dem Transmission-Line-Prinzip auf (201, 202, 203), ein Dämpfungsglied 204 zur Bedämpfung von Mehrfachimpulsen, die Impulsleitungen 205 und 207, die Impulsmeßtechnik (206, 211, 212, 213), den Steuerrechner 214, den Impulsinjektor 215, das Umschaltrelais 208 und die Vorrichtung zur Leckstrommessung 209 und 210.

Die Belastung und Charakterisierung einzelner integrierter Elemente (Transistoren, Dioden, Gateoxide) wird durch den optionalen Einsatz einer zweiten und ggf. dritten Kontaktzunge in die Referenzelektrode möglich (vgl. Fig.5).

Voraussetzung für eine wahlfreie Kontaktierung ist manuell oder motorisch betriebene, um 360° drehbare Substrathalterung, die zumindest auf lateral ±20 um zielgenau motorisch oder manuell bewegt werden kann. Die Vertikalbewegung kann alternativ durch den Manipulator oder den Substratträger (Substrathalterung) erfolgen.
Alternativ kann auf die Drehbarkeit der Halterung verzichtet werden, falls die Kontaktelektrode im Zentrum der Referenzelektrode vorgesehen ist. In diesem Fall ist auch ohne Drehung eine wahlfreie Kontaktierung möglich.

Optional kann das System um eine Impulsmeßtechnik nach dem Prinzip der Zeitbereichsreflektometrie ergänzt werden (vgl. Fig. 4, 5). Dazu wird in die den Belastungsimpuls führende Leitung im Abstand entfernt von der Impulseinkopplung ein für ausreichend spannungsfestes Impulsauskopplungselement 107 eingebaut, das zunächst einen kleinen Teil der Impulsleistung in ein Oszilloskop auskoppelt. Verzögert um die doppelte Impulslaufzeit auf der Leitung zwischen der Impulsauskopplung und der Impulseinkopplung in die integrierte Schaltung trifft die von der integrierten Schaltung reflektierte Welle am Oszilloskop ein. Damit sie sich nicht mit der hinlaufenden Welle überlagert, muß die Impulsdauer kürzer als die doppelte Laufzeit auf diesem Teil der Übertragungsleitung sein. Eine numerische Trennung und Überlagerung im Steuerrechner 106 erlaubt schließlich die Ermittlung von Spannung und Strom am DUT. In jedem Falle erlaubt die Messung eine kontinuierliche Überwachung des Systemzustands und eine einfache Kalibrierung durch Öffnen des Kontakts bzw. Herstellen eines Kurzschlusses.

Die Impulsqualität bezüglich Verzerrungen wird wesentlich von der Qualität insbesondere der Dämpfungsarmut der Kabel und dem Stehwellenverhältnis der Übergänge bestimmt. Die Kabel sind auch nach dem Gesichtspunkt der Spannungsfestigkeit auszuwählen.
Bei kurzzeitigen Impulsen können die Gleichspannungsfestigkeiten allerdings um ein Mehrfaches überschritten werden.

Die impulsleitenden Komponenten können mit einem breitbandigen Abtastoszillographen überprüft und charakterisiert werden.

Zur Steigerung der Effizienz sind auch vor und nach der Belastung die elektrischen Fehlerkriterien zu bestimmen. Hierzu kann alternativ eine mit dem Funktionstester verbundene Nadelkarte eingefahren werden. Optional kann bei der Charakterisierung von Einzelelementen und anderen Strukturen mit zwei Anschlüssen ein HF-Umschaltrelais 208 in den Impulspfad eingefügt werden, um zwischen Belastung und Leckstrommessung umschalten zu können.

Zur Anwendung des erfindungsgemäßen Verfahrens kann auch eine Vorrichtung gemäß Fig. 6 eingesetzt werden. Diese Vorrichtung besteht aus der Referenzelektrode 303 mit einer Vertiefung, in der ein dielektrisches Material 302 konstanter Dicke liegt. Auf dieses Material wird die integrierte Schaltung 301 gelegt. Eine der Anschlußflächen 305 dieser Schaltung wird über die Kontaktelektrode eines Injektors 304 kontaktiert. Die Referenzelektrode steht dabei ebenfalls in elektrischem Kontakt mit dem Injektor. Die Justierung der Referenzelektrode auf einen konstanten Abstand zum Substrat erfolgt bei diesem Beispiel also über das Dielektrikum 302 als Abstandshalter.

Die erfindungsgemäße Vorrichtung und das erfindungsgemäße Verfahren erlauben eine vergleichbare und reproduzierbare Hochstrombelastung integrierter Schaltungen auch auf einer vollständigen oder geteilten Halbleiterscheibe (Wafer).
Durch die Möglichkeit, einen definierten Wellenwiderstand des Gesamtsystems von der Impulserzeugung bis zur Einkopplung vorzusehen, ist der Belastungsimpuls streng definiert und somit ausschließlich von der belasteten integrierten Schaltung abhängig.
Die für CDM-Entladungen geltenden Verhältnisse der Teilkapazitäten auf der integrierten Schaltung werden weitgehend aufrechterhalten.
Durch Einkopplung über die Anschlußpads der integrierten Schaltung werden die Probleme durch verbogene oder zu kleine Anschlüsse vermieden. Eine optische Kontrolle der Kontaktabdrücke auf dem Pad ermöglicht die Beurteilung der Kontaktqualität nach Durchführung der Belastung.
Durch die Möglichkeit der Untersuchung der Schaltungen auf Waferebene werden parasitäre, schwer kontrollierbare Einflüsse durch die Preßmasse von Gehäusen und kapazitätsmindernde Luftspalte zwischen Gehäuse und Auflage vermieden.
Die Vorrichtung kann problemlos in bestehende Systeme wie Prüfautomaten eingesetzt werden.

Das Verfahren und die Vorrichtung eignen sich auch zur Belastung von gehäusten integrierten Schaltungen. Hierbei wird die Referenzelektrode mit dem Gehäusedielektrikum vollständig in Kontakt gebracht. Das Gehäusedielektrikum selbst bildet somit das zwischen Referenzelektrode und integrierter Schaltung vorgesehene Dielektrikum (statt Luft). Voraussetzung hierbei ist, daß das Gehäusedielektrikum die Referenzelektrode von den Bausteinanschlüssen und der integrierten Schaltung isoliert.

## Patentansprüche

1. Vorrichtung zur gepulsten Hochstrombelastung integrierter Schaltungen und Strukturen mit einer Halterung (9, 10) zur Aufnahme eines Substrates (8), das eine oder mehrere zu belastende integrierte Schaltungen und Strukturen (11) enthält, und einem Impulsinjektor, der eine Referenzelektrode (3), eine Kontaktelektrode (7) zur Kontaktierung von Anschlußflächen (12) der integrierten Schaltungen und Strukturen (11), und einen Träger (4) für Kontakt- und Referenzelektrode aufweist,
**dadurch gekennzeichnet,**
**daß** die Referenzelektrode (3) eine ebene Fläche aufweist, die parallel und auf definierten Abstand zur Oberfläche eines in die Halterung (9, 10) eingesetzten Substrates (8) einstellbar ist, wobei die Kontaktelektrode (7) durch eine in der ebenen Fläche der Referenzelektrode vorgesehene Aussparung oder Öffnung ragt.

2. Vorrichtung nach Anspruch 1,
**dadurch gekennzeichnet,**
**daß** die ebene Fläche der Referenzelektrode (3) zwischen 100 und 1000 mm² beträgt.

3. Vorrichtung nach Anspruch 1 oder 2,
**dadurch gekennzeichnet,**
**daß** die Aussparung oder Öffnung so groß ist, daß eine optische Justierung der Kontaktelektrode (7) auf die Anschlußflächen (12) der integrierten Schaltungen durch die Referenzelektrode (3) hindurch möglich ist, und die zwischen Referenzelektrode und integrierter Schaltung bestehenden Teilkapazitäten nicht beeinflußt werden.

4. Vorrichtung nach einem der Ansprüche 1 bis 3,
**dadurch gekennzeichnet,**
**daß** die Halterung (9, 10) aus einer Isolatorplatte besteht.

5. Vorrichtung nach einem der Ansprüche 1 bis 3,
**dadurch gekennzeichnet,**
**daß** die Halterung (9, 10) eine metallische Platte (10) mit einem aufliegenden dielektrischen Material (9) ist.

6. Vorrichtung nach einem der Ansprüche 1 bis 5,
**dadurch gekennzeichnet,**
**daß** die Halterung (9, 10) mittels einer Drehvorrichtung um eine Achse, die senkrecht zur Oberfläche eines in die Halterung eingesetzten Substrates (8) verläuft, um 360° drehbar ist.

7. Vorrichtung nach einem der Ansprüche 1 bis 6,
**dadurch gekennzeichnet,**
**daß** die Referenzelektrode (3) mit einem schrittmotorbetriebenen Manipulator zur Oberfläche des Substrates (8) einstellbar ist.

8. Vorrichtung nach einem der Ansprüche 1 bis 6,
**dadurch gekennzeichnet,**
**daß** die Referenzelektrode (3) über eine schrittmotorbetriebene Substrathalterung zur Oberfläche des Substrates (8) einstellbar ist.

9. Vorrichtung nach einem der Ansprüche 1 bis 8,
**dadurch gekennzeichnet,**
**daß** die Kontaktelektrode (7) im Zentrum der ebenen Fläche der Referenzelektrode (3) vorgesehen ist.

10. Vorrichtung nach einem der Ansprüche 1 bis 9, **dadurch gekennzeichnet, daß** die Kontaktelektrode (7) eine nadelförmige, halbkugelförmige, kegel- oder kegelstumpfförmige Gestalt aufweist.

11. Vorrichtung nach einem der Ansprüche 1 bis 10,
**dadurch gekennzeichnet,**
**daß** die Referenzelektrode (3) mit dem Außenleiter und die Kontaktelektrode (7) mit dem Innenleiter einer koaxialen Impulsleitung oder eines standardisierten HF-Anschlußelementes (5) verbunden sind.

12. Vorrichtung nach Anspruch 11,
**dadurch gekennzeichnet,**
**daß** die Kontaktelektrode (7) über einen transversalen Wellenleiter, insbesondere einen Streifen- oder Koaxialleiter, dessen Wellenwiderstand dem des Gesamtsystems entspricht, mit dem HF-Anschlußelement (5) verbunden ist.

13. Vorrichtung nach einem der Ansprüche 1 bis 12,
**dadurch gekennzeichnet,**
**daß** an der Referenzelektrode (3) eine Halterung für eine weitere Kontaktelektrode (13) vorgesehen ist, die nach der Befestigung mit der Referenzelektrode leitend verbunden ist und durch eine in der ebenen Fläche der Referenzelektrode vorgesehene weitere Öffnung (14) ragt.

14. Vorrichtung nach Anspruch 13,
**dadurch gekennzeichnet,**
**daß** ein HF-Umschaltelement (208) vorgesehen ist, das zwischen einer Verbindung der Referenz- und Kontaktelektrode mit einer angeschlossenen Impulserzeugungsvorrichtung (201, 202, 203) zur Belastung und einer Verbindung der Referenz- und Kontaktelektrode mit einer Vorrichtung (209, 210) zur Kennlinienmessung umschalten kann.

15. Vorrichtung nach einem der Ansprüche 1 bis 14,
**dadurch gekennzeichnet,**
**daß** Referenz- und Kontaktelektrode mit einer Impulserzeugungsvorrichtung (201, 202, 203) verbunden sind, die nach dem Transmission-Line-Verfahren arbeitet.

16. Vorrichtung nach Anspruch 15,
**dadurch gekennzeichnet,**
**daß** die den Belastungsimpuls führende Leitung der Impulserzeugungsvorrichtung in einem Abstand von der Impulseinkopplung ein spannungsfestes Impulsauskopplungselement (107, 206) aufweist, das einen kleinen Teil der Impulsleistung in ein Oszilloskop (105, 213) zur Durchführung einer Zeitbereichsreflektometrie-Messung auskoppelt.

17. Vorrichtung nach Anspruch 15 oder 16,
**dadurch gekennzeichnet,**
**daß** die Impulserzeugungsvorrichtung zur Impulserzeugung mit einem koaxialen Relais oder Festkörperschalter ausgestattet ist.

18. Verfahren zur gepulsten Hochstrombelastung integrierter Schaltungen und Strukturen mit folgenden Verfahrensschritten:
- Justieren einer Referenzelektrode (3, 303) mit einer ebenen Fläche parallel und auf definierten Abstand zur Oberfläche eines Substrates mit einer oder mehreren zu belastenden integrierten Schaltungen oder Strukturen (11, 301), so daß die ebene Fläche der Referenzelektrode die jeweilige zu belastende integrierte Schaltung oder Struktur des Substrates zumindest nahezu vollständig überdeckt,
- Justieren einer Kontaktelektrode (7) auf die Anschlußflächen (12, 305) der zu belastenden integrierten Schaltung oder Struktur,
- Kontaktieren der Kontaktelektrode mit der Anschlußfläche der zu belastenden integrierten Schaltung oder Struktur, und
- Beaufschlagen der Kontaktelektrode mit einem definierten Stromimpuls zur gepulsten Hochstrombelastung.

19. Verfahren nach Anspruch 18,
**dadurch gekennzeichnet,**
**daß** eine Referenzelektrode (3, 303) eingesetzt wird, deren ebene Fläche die jeweilige zu untersuchende integrierte Schaltung (11, 301) des Substrates auf zumindest drei Seiten lateral um einen Abstand überragt, der größer ist als der definierte Abstand der Referenzelektrode zur Substratoberfläche.

20. Verfahren nach Anspruch 18 oder 19,
**dadurch gekennzeichnet,**
**daß** das Substrat vor dem Schritt des Justierens der Referenzelektrode auf eine Halterung (9, 10) aufgebracht wird, die sich aus einer metallischen Platte (10) mit einem aufliegenden dielektrischen Material (9) zusammensetzt, dessen Dicke und Dielektrizitätskonstante so bemessen sind, daß der Kapazitätsbeitrag, den die Halterung zur Kapazität des Systems aus Referenzelektrode, Substrat und Halterung liefert, vernachlässigbar klein ist.

21. Verfahren nach einem der Ansprüche 18 bis 20,
**dadurch gekennzeichnet,**
**daß** zwischen Referenzelektrode (3, 303) und Substratoberfläche ein beliebiges Dielektrikum (302) gebracht wird.

22. Verfahren nach einem der Ansprüche 18 bis 21,
**dadurch gekennzeichnet,**
**daß** die Justierung der Kontaktelektrode (7) durch eine Aussparung oder Öffnung in der Referenzelektrode (3) hindurch mittels einem Mikroskop oder einem elektronischen Bilderkennungssystem erfolgt.

23. Verfahren nach einem der Ansprüche 18 bis 22,
**dadurch gekennzeichnet,**
**daß** die Impulserzeugung zum Beaufschlagen der Kontaktelektrode mit einem Stromimpuls nach dem Transmission-Line-Verfahren erfolgt.

24. Verfahren nach einem der Ansprüche 18 bis 23,
**dadurch gekennzeichnet,**
**daß** unter Einsatz eines Waferprobers nacheinander mehrere integrierte Schaltungen auf dem gleichen Substrat kontaktiert und mit gleichen oder unterschiedlichen Belastungspegeln belastet werden.

25. Verfahren nach einem der Ansprüche 18 bis 24,
**dadurch gekennzeichnet,**
**daß** nach der Belastung eine mit einem Funktionstester verbundene Nadelkarte zur Kontaktierung der integrierten Schaltung eingefahren wird.

26. Verfahren nach einem der Ansprüche 18 bis 25,
**dadurch gekennzeichnet,**
**daß** die Justierung der Kontaktelektrode automatisch auf Grundlage einer vorhandenen CAD-Datenbasis erfolgt, sobald die genaue Lage der integrierten Schaltung identifiziert ist.

## Claims

1. Device for pulsed high-current stressing of integrated circuits and structures, comprising a mount (9, 10) for receiving a substrate (8) including one or several integrated circuits and structures (11) to be stressed, and a pulse injector which comprises a reference electrode (3), a contact electrode (7) for contacting terminal areas (12) of said integrated circuits and structures (11), and a support (4) for said contact and reference electrodes,
**characterised in**
**that** said reference electrode (3) has a plane surface adjustable in parallel with and to a defined spacing from the surface of a substrate (8) inserted into said mount (9, 10), with said contact electrode (7) projecting through a recess or opening provided in said plan surface of said reference electrode.

2. Device according to Claim 1,
**characterised in**
**that** said plane surface of said reference electrode (3) has a size of 100 to 1000 mm².

3. Device according to Claim 1 or 2,
**characterised in**
**that** said recess or opening is so wide that an optical adjustment of said contact electrode (7) relative to the terminal areas (12) of said integrated circuits through said reference electrode (3) will be possible, and that the partial capacitances existing between said reference electrode and said integrated circuit will not be influenced.

4. Device according to any of the Claims 1 to 3,
**characterised in**
**that** said mount (9, 10) consists of an insulating plate.

5. Device according to any of the Claims 1 to 3,
**characterised in**
**that** said mount (9, 10) is a metal plate (10) with a dielectric material (9) resting thereon.

6. Device according to any of the Claims 1 to 5,
**characterised in**
**that** said mount (9, 10) is rotatable by means of a rotating means through 360° about an axis extending orthogonally on the surface of a substrate (8) inserted into said mount.

7. Device according to any of the Claims 1 to 6,
**characterised in**
**that** said reference electrode (3) is adapted for being adjusted by means of a manipulator operated by a stepping motor, relative to the surface of said substrate (8).

8. Device according to any of the Claims 1 to 6,
**characterised in**
**that** said reference electrode (3) is adapted for being adjusted by means of a substrate mount operated by a stepping motor, relative to the surface of said substrate (8).

9. Device according to any of the Claims 1 to 8,
**characterised in**
**that** said contact electrode (7) is provided in the centre of said plane surface of said reference electrode (3).

10. Device according to any of the Claims 1 to 9,
**characterised in**
**that** said contact electrode (7) comprises a needle-shaped, semi-spherical, conical or frusto-conical configuration.

11. Device according to any of the Claims 1 to 10,
**characterised in**
**that** said reference electrode (3) is connected to the exterior conductor and that said contact electrode (7) is connected to the interior conductor of a coaxial pulse line or a standardised HF connector element (5).

12. Device according to Claim 11,
**characterised in**
**that** said contact electrode (7) is connected to said HF connector element (5) via a transverse wave guide, specifically a strip or coaxial guide having an intrinsic capacity corresponding to that of the entire system.

13. Device according to any of the Claims 1 to 12,
**characterised in**
**that** a mount is provided for a further contact electrode (13) on said reference electrode (3), which further electrode when fastened is conductively connected to said reference electrode and projects through a further opening (14) formed in the plane surface of said reference electrode.

14. Device according to Claim 13,
**characterised in**
**that** an HF switch-over element (208) is provided which is adapted for switching over between a connected pulse generator means (201, 202, 203) for stressing and a device (209, 210) for measuring the steady state characteristic.

15. Device according to any of the Claims 1 to 14,
**characterised in**
**that** said reference and contact electrodes are connected to a pulse generator means (201, 202, 203) which operates on the basis of the transmission line technique.

16. Device according to Claim 15,
**characterised in**
**that** the line of said pulse generator means, which carries the stressing pulse, comprises a voltage-stable pulse output coupler element (107, 206) at a spacing from the pulse input coupler element, which couples out a small fraction of the pulse power into an oscilloscope (105, 213) for time range reflectometric measurement.

17. Device according to Claim 15 or 16,
**characterised in**
**that** said pulse generator means is equipped with a coaxial relay or a solid-state switch for pulse generation.

18. Method of pulsed high-current stressing of integrated circuits and structures, comprising the following steps of operation:
- adjustment of a reference electrode (3, 303) with a plane surface in parallel with and at a defined spacing from the surface of a substrate with one or several integrated circuits or structures (11, 301) to be stressed, such that said plane surface of said reference electrode covers the respective integrated circuit or structure of said substrate, which is to be stressed, at least almost completely,
- adjustment of a contact electrode (7) relative to the terminal areas (12, 305) of said integrated circuit or structure to be stressed,
- contacting said contact electrode with said terminal area of said integrated circuit or structure to be stressed, and
- applying a defined current pulse at said contact electrode for pulsed high-current stressing.

19. Method according to Claim 18,
**characterised in**
**that** a reference electrode (3, 303) is inserted which has a plane surface projecting beyond the respective integrated circuit (11, 301) of said substrate, which is to be analysed, laterally on at least three sides by a distance which exceeds the spacing of said reference electrode from said substrate surface.

20. Method according to Claim 18 or 19,
**characterised in**
**that** prior to the step of adjustment of said reference electrode said substrate is placed on a mount (9, 10) composed of a metal plate (10) with a dielectric material (9) placed thereon which has a thickness and a dielectric constant so dimensioned that the capacitance contributed by said mount to the capacitance of the system consisting of said reference electrode, said substrate and said mount will be negligibly small.

21. Method according to any of the Claims 18 to 20,
**characterised in**
**that** an optional dielectric (302) is interposed between said reference electrode (3, 303) and the substrate surface.

22. Method according to any of the Claims 18 to 21,
**characterised in**
**that** the adjustment of said contact electrode (7) is performed through a recess or opening in said reference electrode (3) by means of a microscope or an electronic video recognition system.

23. Method according to any of the Claims 18 to 22,
**characterised in**
**that** the pulse generation for applying a current pulse at said contact electrode is performed on the basis of the transmission line technique.

24. Method according to any of the Claims 18 to 23,
**characterised in**
**that** with application of a wafer prober several integrated circuits on the same substrate are contacted in succession and stressed with the same or different stressing levels.

25. Method according to any of the Claims 18 to 24,
**characterised in**
**that** after stressing a needle board connected to a functional tester is inserted for contacting said integrated circuit.

26. Method according to any of the Claims 18 to 25,
**characterised in**
**that** the adjustment of said contact electrode is performed automatically on the basis of an existing CAD data basis as soon as the precise position of said integrated circuit has been identified.

## Revendications

1. Dispositif à charger des circuits intégrés et des structures par un courant très fort à impulsions, comprenant une base (9, 10) à recevoir un substrat (8), qui contient un ou plusieurs circuits et structures (11 ) intégrés à charger, et un injecteur d'impulsions, qui comprend une électrode de référence (3), une électrode de contact (7) à contacter des aires de raccord (12) des circuits et structures intégrés (11), et une base (4) pour l'électrode de contact et de référence,
**caractérisé en ce**
**que** l'électrode de référence (3) présente une surface plane, qui est ajustable en parallèle à et à un écart défini de la surface d'un substrat (8) placé dans ladite base (9, 10), l'électrode de contact (7) faisant saillie à travers un évidement ou une ouverture formé dans ladite surface plane de ladite électrode de référence.

2. Dispositif selon la revendication 1,
**caractérisé en ce**
**que** la surface plane de ladite électrode de référence (3) correspond à une grandeur entre 100 et 1000 mm².

3. Dispositif selon la revendication 1 ou 2,
**caractérisé en ce**
**que** ledit évidement ou ladite ouverture est d'une taille afin de permettre un ajustement optique de ladite électrode de contact (7) sur lesdites aires de raccord (12) desdits circuit intégrés à travers ladite électrode de référence (3), et afin d'éviter des l'influence sur les capacités partielles, qui existent entre l'électrode de référence et le circuit intégré.

4. Dispositif selon une quelconque des revendications 1 à 3,
**caractérisé en ce**
**que** ledit support (9, 10) consiste en une plaque isolante.

5. Dispositif selon une quelconque des revendications 1 à 3,
**caractérisé en ce**
**que** ledit support (9, 10) est une plaque métallique (10) à un matériau (9) diélectrique placé sur lui.

6. Dispositif selon une quelconque des revendications 1 à 5,
**caractérisé en ce**
**que** ledit support (9, 10) est capable de tourner par 360° moyennant un moyen de rotation, autour d'un axe qui s'étend en sens orthogonal sur la surface d'un substrat (8) placé dans ledit support.

7. Dispositif selon une quelconque des revendications 1 à 6,
**caractérisé en ce**
**que** ladite électrode de référence (3) est ajustable relativement à la surface dudit substrat (8) moyennant un manipulateur entraîné par un moteur à pas.

8. Dispositif selon une quelconque des revendications 1 à 6,
**caractérisé en ce**
**que** ladite électrode de référence (3) est ajustable relativement à la surface dudit substrat (8) moyennant un support de substrat entraîné par un moteur à pas.

9. Dispositif selon une quelconque des revendications 1 à 8,
**caractérisé en ce**
**que** ladite électrode de contact (7) est disposé au centre de ladite surface plane de ladite électrode de référence (3).

10. Dispositif selon une quelconque des revendications 1 à 9,
**caractérisé en ce**
**que** ladite électrode de contact (7) a une configuration sous forme d'aiguille, de demi sphère, conique ou en cône tronconique.

11. Dispositif selon une quelconque des revendications 1 à 10,
**caractérisé en ce**
**que** ladite électrode de référence (3) est reliée au conducteur extérieur et ladite électrode de contact (7) est relié au conducteur intérieur d'une ligne coaxiale d'impulsions ou d'un élément de raccord HF standardisé (5).

12. Dispositif selon la revendication 11,
**caractérisé en ce**
**que** ladite électrode de contact (7) est raccordé audit élément de raccord HF (5) via un guide d'onde transversal, en particulier un conducteur à bande ou coaxial, dont l'impédance caractéristique correspond à l'impédance caractéristique du système complet.

13. Dispositif selon une quelconque des revendications 1 à 12,
**caractérisé en ce**
**qu'**un support est disposé pour une électrode de contact additionnelle (13) Jà ladite électrode de référence (3), qui, suivant la fixation, est raccordé, de façon conductible, à ladite électrode de référence et qui fait saillie à travers une ouverture additionnelle (14), qui est prévue dans ladite surface plane de ladite électrode de référence.

14. Dispositif selon la revendication 13,
**caractérisé en ce**
**qu'**un élément commutateur HF (208) est disposé, qui est capable de commuter entre une connexion de ladite électrode de référence et de contact à un moyen générateur d'impulsions raccordé (201, 202, 203) pour le chargement, et une connexion de ladite électrode de référence et de contact à un moyen (209, 210) pour la mesure de la caractéristique.

15. Dispositif selon une quelconque des revendications 1 à 14,
**caractérisé en ce**
**que** lesdites électrodes de référence et de contact sont reliées à un moyen générateur d'impulsions (201, 202, 203), qui fonctionne selon la technique dite Transmission Line.

16. Dispositif selon la revendication 15,
**caractérisé en ce**
**que** la ligne dudit moyen générateur d'impulsions, qui transmet l'impulsion de chargement, comprend un élément coupleur de sortie (107, 206) à tenue suffisante sous tension, à un écart du point d'introduction des impulsions, cet élément sortant une petite fraction de l'énergie d'impulsions à un oscilloscope (105, 213) pour réaliser une mesure à réflectométrie des intervalles.

17. Dispositif selon la revendication 15 ou 16,
**caractérisé en ce**
**que** ledit moyen générateur d'impulsions est équipé d'un relais coaxial ou d'un commutateur solide pour la génération des impulsions.

18. Procédé de chargement des circuits et structures intégrés en courant très fort, comprenant les opérations suivantes:
- ajustement d'une électrode de référence (3, 303) à une surface plane en parallèle à et à un écart défini de la surface d'un substrat à un ou plusieurs circuits ou structures intégrés (11, 301) à charger, de façon que ladite surface plane de ladite électrode de référence recouvre le circuit ou la structure intégré respectif à charger du substrat au moins presque complètement,
- ajustement d'une électrode de contact (7) aux aires de raccord (12, 305) du circuit ou de la structure intégré à charger,
- établissement d'un contact de ladite électrode de contact avec l'aire de raccord du circuit ou de la structure intégré à charger, et
- application d'une impulsion de courant définie à ladite électrode de contact pour le chargement à courant très fort aux impulsions.

19. Procédé selon la revendication 18,
**caractérisé en ce**
**qu'**une électrode de référence (3, 303) est employée, dont la surface plane fait latéralement saillie du circuit intégré respectif à étudier (11, 301) du substrat à au moins trois côtés par une distance, qui est plus grande que l'écart défini de l'électrode de référence relativement à la surface du substrat.

20. Procédé selon la revendication 18 ou 19,
**caractérisé en ce**
**qu'**avant l'opération d'ajustement de ladite électrode de référence, ledit substrat est placé sur un support (9, 10) qui est composé d'une plaque métallique (10) à un matériau diélectrique (9) disposé sur elle, dont l'épaisseur et la constante diélectrique sont si dimensionnées que la fraction de capacité contribuée par le support à la capacité du système formé par l'électrode de référence, substrat et support, est négligeable.

21. Procédé selon une quelconque des revendications 18 à 20,
**caractérisé en ce**
**qu'**un diélectrique quelconque (302) est introduit entre l'électrode de référence (3, 303) et la surface du substrat.

22. Procédé selon une quelconque des revendications 18 à 21,
**caractérisé en ce**
**que** l'ajustement de ladite électrode de contact (7) se fait à travers un évidemment ou une ouverture dans l'électrode de référence (3) moyennant un microscope ou un système de reconnaissance d'images électronique.

23. Procédé selon une quelconque des revendications 18 à 22,
**caractérisé en ce que** la génération des impulsions pour l'application d'une impulsion de courant à ladite électrode de contact se fait en correspondance avec la technique dite Transmission Line.

24. Procédé selon une quelconque des revendications 18 à 23,
**caractérisé en ce**
**qu'**une pluralité de circuits intégrés sur le même substrat sont contactés l'un après l'autre et chargé au même niveau ou aux niveaux de charge différents par l'emploi d'un dispositif d'essai de galettes.

25. Procédé selon une quelconque des revendications 18 à 24,
**caractérisé en ce**
**qu'**après le chargement, une carte à fiches raccordée à un dispositif d'essai des fonctions est introduit pour l'établissement de contact avec le circuit intégré.

26. Procédé selon une quelconque des revendications 18 à 25,
**caractérisé en ce**
**que** l'ajustage de ladite électrode de contact se fait de façon automatisée à la base d'une base de données CAD existante dès que la position précise du circuit intégré est identifié.
